# EUROPÄISCHE PATENTANMELDUNG

(11) **EP 2 736 310 A2**
(43) Veröffentlichungstag der Anmeldung: **28.05.2014**
(21) Anmeldenummer: 13193870.6
(22) Anmeldetag: 21.11.2013
(51) Int. Cl.: H05K 5/00, H05K 7/14

(54) **Elektronisches Gerät mit elektrisch leitender Deckelverbindung**

(30) Priorität: 27.11.2012 DE 102012111491
(71) Anmelder: SMA Solar Technology AG, 34266 Niestetal (DE)
(72) Erfinder: LISITSCHEW, Swetlana, 34117 Kassel (DE)

(57) **Zusammenfassung**

Ein elektronisches Gerät (1) ist mit einem Boden (3) als erstem Gehäuseteil und einem Deckel (2) als zweitem Gehäuseteil versehen, wobei das erste und das zweite Gehäuseteil zumindest teilweise aus leitfähigem Material ausgebildet ist. In einem Montagezustand ist das elektronische Gerät (1) durch ein jeweils einem der beiden Gehäuseteile zugehöriges Befestigungspaar elektrisch verbunden, wobei das Befestigungspaar einen Dorn (7) mit mindestens drei Druckkanten (9) und eine Ausnehmung (8) mit einem dem Dorn angepassten Öffnungsquerschnitt aufweist. Der Dorn (7) ragt im Montagezustand derart in die Ausnehmung (8) hinein, dass zwischen den Druckkanten (9) und Wänden der Ausnehmung (8) eine Haltekraft zwischen den beiden Gehäuseteilen ausgeübt wird.

## Beschreibung

### TECHNISCHES GEBIET DER ERFINDUNG

Die Erfindung bezieht sich auf ein elektronisches Gerät, insbesondere einen Wechselrichter, speziell einen Modul-Wechselrichter. Das elektronische Gerät umfasst Gehäuseteile, die in einem Montagezustand elektrisch miteinander verbunden sind.

### STAND DER TECHNIK

Elektronische Geräte werden regelmäßig in leitfähigen Gehäuseteilen untergebracht und diese werden mit einem Bezugspotenzial wie dem Erdpotenzial verbunden. Dies stellt sicher, dass Gefahren durch Berührung des Gehäuses ausgeschlossen werden, die dadurch entstehen, dass elektrische Potenziale, die im Inneren des Gehäuses während des Betriebes aufgebaut werden, auf Teile des Gehäuses übertragen werden. Insbesondere bei Wechselrichtern für die Photovoltaik können durch einen angeschlossenen Solargenerator lebensgefährliche Spannungen von einigen hundert Volt auftreten, sodass eine zuverlässige Erdung aller berührbaren Gehäuseteile erforderlich ist.

Es ist bekannt, die einzelnen Gehäuseteile miteinander zu verschrauben, um gleichzeitig eine zuverlässige Fixierung der Gehäuseteile aneinander und eine zuverlässige elektrische Verbindung zwischen den Teilen zu erreichen. Hierbei ist es gerade bei lackierten oder pulverbeschichteten Gehäuseteilen erforderlich, zusätzlich unter die Schrauben jeweils eine Kontaktscheibe zu legen, die beim Verschrauben die Beschichtung durchdringt, um den elektrischen Kontakt zwischen der Schraube und dem Gehäuseteil sicherzustellen. Der Montageaufwand bei dieser Verbindungstechnik ist erheblich, so dass ein Bedarf besteht, die damit verbundenen Kosten durch andere Verbindungstechniken einzusparen.

Die Druckschrift DE 10 2009 008 527 A1 offenbart ein Gehäuse für Sensorelektronik, bei dem ein Deckel stegförmige Ausformungen aufweist, die bei der Montage des Deckels in entsprechende Ausformungen des Gehäuses eingreifen und durch plasto-elastische Verformung eine mechanische Halterung des Deckels erreichen. Der Deckel kann anschließend mit dem Gehäuse verschweißt oder verklebt werden.

Die Druckschrift DE 198 02 363 C2 beschreibt ein Gehäuse mit umlaufenden Eingriffsbereich entlang eines Öffnungsrandes, in den sich Eingriffszinken einer Abdeckung zur Fixierung der Abdeckung auf dem Gehäuse einkrallen können.

Die Druckschrift DE 44 33 095 C2 offenbart ein Befestigungsverfahren, sowie ein zugeordnetes Befestigungsmittel zum Verbinden zweier Metallplatten als Weiterentwicklung von in dieser Schrift genannten bekannten Nietverbindungen.

Aus der Druckschrift DE 86 03 925 geht eine Klemmverbindung mittels eines Bolzens hervor, während sich die Druckschrift DE 42 15 041 A1 mit einem elektronischen Steuergerät mit Kunststoffrahmen befasst, bei dem Haltestifte die Gehäuseteile nach dem Zusammenfügen mittels pilzförmiger Verformung zusammenhalten.

### AUFGABE DER ERFINDUNG

Der Erfindung liegt die Aufgabe zugrunde, eine elektronisches Gerät aufzuzeigen, bei dem Deckel und Boden auf besonders einfache und kostengünstige Weise derart montierbar sind, dass zwischen ihnen nach der Montage dauerhaft eine elektrische Verbindung besteht.

### LÖSUNG

Die Aufgabe der Erfindung wird durch ein elektronisches Gerät mit den Merkmalen des unabhängigen Patentanspruchs 1 gelöst. Bevorzugte Ausführungsformen der Vorrichtung sind in den abhängigen Patentansprüchen 2 bis 10 definiert.

### BESCHREIBUNG DER ERFINDUNG

Ein erfindungsgemäßes elektronisches Gerät weist einen Boden als erstes Gehäuseteil und einen Deckel als zweites Gehäuseteil auf. Beide Gehäuseteile sind vollständig oder zumindest teilweise aus leitfähigem Material ausgebildet oder weisen eine leitfähige Beschichtung auf und sind in einem Montagezustand des elektronischen Gerätes durch ein Befestigungspaar elektrisch miteinander verbunden, welches einen Dorn mit mindestens drei Druckkanten und eine Ausnehmung mit einem dem Dorn angepassten Öffnungsquerschnitt umfasst. Der Dorn gehört einem und die Ausnehmung dem anderen der beiden Gehäuseteile an. Der Dorn ragt im Montagezustand derart in die Ausnehmung hinein, dass zwischen den Druckkanten des Dornes und den Wänden der Ausnehmung eine Haltekraft zwischen den beiden Gehäuseteilen ausgeübt wird.

In einer Ausführung des elektronischen Gerätes ist der Dorn Bestandteil des Deckels und vorzugsweise gemeinsam mit dem Deckel als einstückiges Gehäuseteil ausgebildet. Entsprechend kann die Ausnehmung gemeinsam mit dem Boden als einstückiges Gehäuseteil ausgebildet sein. Alternativ kann der Dorn aber ebenfalls Bestandteil des Bodens und mit diesem als einstückiges Gehäuseteil ausgebildet sein mit der Ausnehmung als Teil des Deckels. Hierbei ist besonders bevorzugt, den Boden und/oder den Deckel des elektronischen Gerätes mittels eines Druckgussverfahrens, insbesondere eines Aluminium-Druckgussverfahrens herzustellen. Auf diese Weise ist es insbesondere denkbar, die Gehäuseteile und die Befestigungselemente in einem Schritt herzustellen, ohne dass eine weitere Bearbeitung erforderlich ist.

In einer erfindungsgemäßen Ausführungsform werden der Boden und der Deckel mit einer klebenden Dichtung, insbesondere einer Silikondichtung, versehen, um gemeinsam ein dichtes Gehäuse des elektronischen Gerätes zu bilden. Optional ist es denkbar, zusätzlich eine Anschlussplatte vorzusehen, die zwischen Boden und Deckel angebracht ist und mit Boden und Deckel über eine klebende Dichtung verbunden ist. Das elektronische Gerät wird in einem Montagezustand in diesem Fall sowohl durch die Haltekraft des Befestigungspaares als auch durch die Klebekraft der klebenden Dichtung zusammengehalten.

Die Druckkanten des Dorns stellen in Kombination mit den Wänden der Ausnehmung eine zuverlässige elektrische Verbindung zwischen den beiden Gehäuseteilen her. Hierbei ist eine Ausführung, in der der Dorn einen dreieckigen Querschnitt und somit genau drei Druckkanten aufweist, besonders vorteilhaft, auch wenn beispielsweise Querschnittsformen mit vier, fünf oder mehr Druckkanten nicht ausgeschlossen werden. Die Ausnehmung wird in einem dem zugeordneten Dorn angepassten Öffnungsquerschnitt gestaltet. Hierbei werden die Innenwände der Ausnehmung so geformt, dass der Abstand der Innenwandbereiche, die im Montagezustand in Kontakt mit den Druckkanten des Dornes stehen, einen geringfügig kleineren Innenabstand zueinander aufweisen als der Außenabstand der entsprechenden Bereiche der Druckkanten des Dornes. Auf diese Weise wird im Montagezustand eine hohe Anpresskraft der Druckkanten auf die Innenwände der Ausnehmung ausgeübt und gleichzeitig eine Verkantung des Dorns beim Einführen in die Ausnehmung vermieden. Eine ausreichend hohe Anpresskraft der Druckkanten auf die Innenwände der Ausnehmung führt zu einer lokalen kalten Verschweißung der genannten Komponenten und damit zu einer besonders zuverlässigen elektrischen und mechanischen Verbindung zwischen den Gehäuseteilen. Dieser Effekt der kalten Verschweißung kann durch eine geeignete Behandlung der Oberflächen des Dornes und/oder der Ausnehmung verstärkt werden. Vorteilhafterweise kann die Ausnehmung rund sein. Weiterhin kann der Dorn oder die Ausnehmung mit Oberflächenstrukturen wie Stufen, Riefen, Unterschnitte oder Aufrauhungen versehen sein, die die elektrischen und mechanischen Eigenschaften der Verbindung zwischen den Gehäuseteilen nach dem Zusammenfügen verbessern und beispielsweise eine Rastfunktion ausüben.

Bevorzugt wird der Dorn mit einer konischen Form versehen, in der der Querschnitt des Dorns von seiner Wurzel hin zu seiner Spitze kontinuierlich oder in Stufen abnimmt. Hierbei wird der Neigungswinkel der konischen Form des Dornes und der Neigungswinkel der Innenwände der Ausnehmung bevorzugt einander angeglichen, so dass nach Einführung des Dornes in die Ausnehmung eine gleichmäßige Anpresskraft zwischen Druckkanten des Dornes und Innenwand der Ausnehmung über die Länge der Druckkanten erreicht wird.

Auch wenn es denkbar ist, Deckel und Boden zusätzlich durch Schrauben miteinander zu verbinden, sind in einer erfindungsgemäßen Ausführungsform des elektronischen Gerätes Deckel und Boden im Montagezustand durch eine schraubenfreie Verbindung miteinander elektrisch und mechanisch verbunden. Auf diese Weise kann der Zusammenbau des elektronischen Gerätes in besonders einfacher und kostengünstiger Weise erfolgen.

Das elektronische Gerät kann vorteilhafterweise ein Wechselrichter, insbesondere ein Wechselrichter für die Photovoltaik, sein. Seine besonderen Vorzüge kann die Montagetechnik insbesondere bei der Verwendung innerhalb eines Modul-Wechselrichters zur Geltung bringen, da diese Wechselrichter eine kleine Bauform und ein geringes Gewicht aufweisen und in hohen Stückzahlen hergestellt werden.

Vorteilhafte Weiterbildungen der Erfindung ergeben sich aus den Patentansprüchen, der Beschreibung und den Zeichnungen. Die in der vorliegenden Beschreibung genannten Vorteile von Merkmalen beziehungsweise von Kombinationen mehrerer Merkmale sind lediglich exemplarischer Natur und können alternativ oder kumulativ zur Wirkung kommen, ohne dass die Vorteile von erfindungsgemäßen Ausführungsformen zwingend erzielt werden müssen. Die in der Beschreibung offenbarten Ausführungsformen dienen dem Fachmann als Optionen für die Ausführung der Erfindung, wobei die Erfindung jedoch nicht auf diese Ausführungsbeispiele beschränkt ist. Der Fachmann wird diese Ausführungsbeispiele als Anregungen ansehen, um andere Ausgestaltungen der Erfindung - auch mit hier nicht konkret offenbarten Varianten der Ausführung ihrer Merkmale - anhand des konkreten Bedarf des Einzelfalls abzuleiten.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn hingegen nur die genaue Anzahl eines Merkmals angegeben werden soll, findet das Adjektiv "genau" vor dem jeweiligen Merkmal Verwendung. Diese Merkmale können durch andere Merkmale ergänzt werden oder die einzigen Merkmale sein, aus denen das jeweilige Erzeugnis besteht.

### KURZBESCHREIBUNG DER FIGUREN

Die Erfindung wird im Folgenden anhand von Ausführungsbeispielen unter Bezugnahme auf die beigefügten Zeichnungen näher erläutert und beschrieben.
- **Fig. 1**: zeigt eine Explosionszeichnung von Komponenten eines erfindungsgemäßen elektronischen Gerätes.
- **Fig. 2**: zeigt eine perspektivische Darstellung einer erfindungsgemäßen Ausführungsform eines Deckels.
- **Fig. 3**: zeigt einen Ausschnitt eines Deckels mit einer erfindungsgemäßen Ausführung eines Dornes.
- **Fig. 4**: zeigt eine perspektivische Darstellung einer erfindungsgemäßen Ausführungsform eines Bodens;
- **Fig. 5**: zeigt einen Ausschnitt eines Bodens mit einer erfindungsgemäßen Ausführung einer Ausnehmung.

### FIGURENBESCHREIBUNG

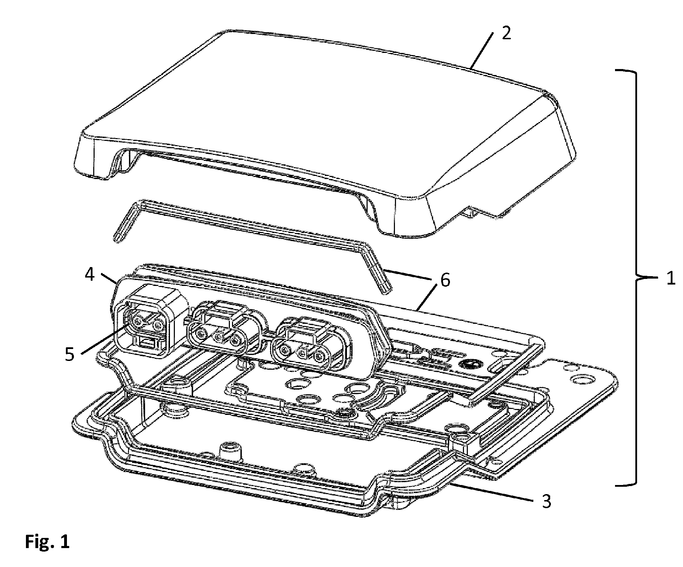

**Fig. 1** zeigt Gehäuse-Komponenten eines elektronischen Gerätes 1 in einer Explosionszeichnung. Ein Deckel 2 bildet gemeinsam mit einem Boden 3 und einer Anschlussplatte 4 ein Gehäuse des elektronischen Gerätes 1, das hier als Modul-Wechselrichter dargestellt ist. Im Inneren des Gehäuses kann eine hier nicht gezeigte Leiterplatte mit elektronischen Komponenten angeordnet sein. Elektrische Anschlüsse für die elektronischen Komponenten können mithilfe von Steckverbindungen 5, die Teil der Anschlussplatte 4 sind, aus dem Gehäuse herausgeführt werden. Die Dichtigkeit des Gehäuses wird mithilfe von Dichtungen 6 erreicht, die zwischen dem Deckel 2, der Anschlussplatte 4 und dem Boden 3 angeordnet sind. Diese Dichtungen können Gummidichtungen sein, aber ebenso klebende Dichtungen, insbesondere Silikondichtungen, die vor dem Zusammenfügen des Gehäuses in eine entsprechende Nut einer oder mehrerer der genannten Gehäusekomponenten eingelegt oder eingespritzt werden. Beim Zusammenfügen des Gehäuses werden entsprechende korrespondierende Dichtungsflächen von anderen Gehäusekomponenten auf die Dichtfläche aufgedrückt und verschließen so das Gehäuse gegen das Eindringen von Verschmutzung und Feuchtigkeit. Da die Dichtungen typischerweise aus elektrisch nicht leitendem Material hergestellt werden, kann eine elektrische Verbindung zwischen den Gehäuseteilen über die Dichtung nicht erreicht werden.

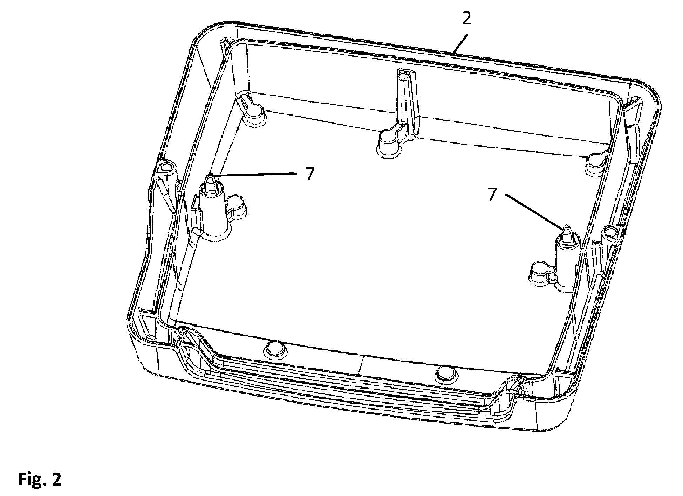

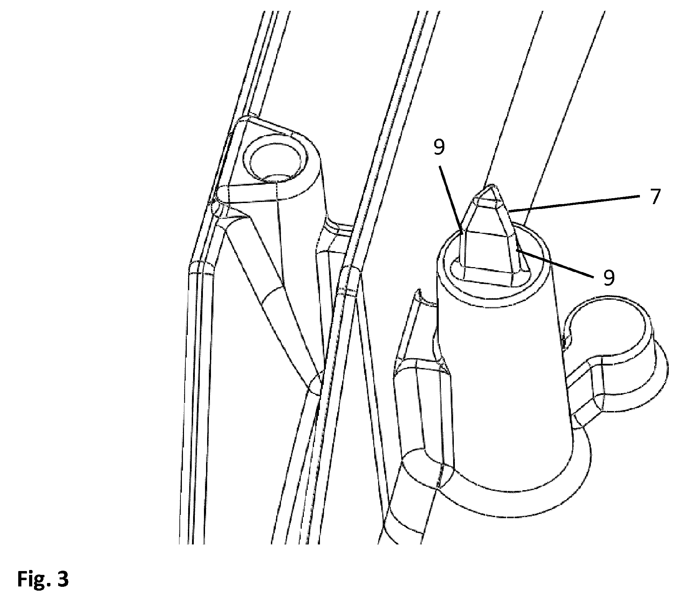

**Fig. 2** zeigt einen Deckel 2 eines elektronischen Gerätes 1 in perspektivische Darstellung. Im Innenbereich des Deckels sind zwei Dorne 7 dargestellt, die an gegenüberliegenden Seiten des Deckels 2 angeordnet sind. Die Form der Dorne ist in dem Ausschnitt der **Fig. 3** genauer gezeigt. Der Dorn weist hier einen dreieckigen Querschnitt auf, so dass sich drei Druckkanten 9 ergeben. Der Querschnitt des Dornes 7 nimmt von der Wurzel zur Spitze hin ab, so dass sich eine konische Form ergibt. Durch die konische Form wird unter anderem eine Zentrierung des Dornes in Verbindung mit einer entsprechenden Ausnehmung bei der Montage erreicht. Die Zentrierung kann weiter verbessert werden, indem im Bereich der Spitze des Dornes 7 ein Bereich vorgesehen wird, in dem sich der Querschnitt stärker verjüngt.

Es ist denkbar, eine beliebige Anzahl von Dornen über das Gehäuseteil, in diesem Fall den Deckel 2, zu verteilen. Vorzugsweise werden jedoch mindestens zwei Dorne vorgesehen, um eine zuverlässige elektrische Verbindung und eine zuverlässige Haltekraft des Deckels nach der Montage zu erreichen.

Die Dorne 7 sind in einstückiger Ausfertigung als Teil des Deckels 2 ausgeführt und werden bei der Formgebung des Deckels mit erzeugt. Es ist zwar denkbar, die Dorne 7 erst nach Herstellung des Deckels 2 als eigenständige Bauteile in Ausnehmungen des Deckels 2 einzufügen, aber dies würde erhöhten Fertigungsaufwand durch einen zusätzlichen Montageschritt bedeuten. Der Deckel 2 könnte beispielsweise in einem Aluminium-Druckgussverfahren hergestellt werden, wodurch die Dorne ohne Zusatzaufwand und ohne Nachbearbeitung gemeinsam mit dem Deckel erzeugbar sind. Es kann aber selbstverständlich eine Nachbearbeitung der Dorne vorgesehen werden, zum Beispiel um die elektrischen Eigenschaften oder die Halteeigenschaften des in eine Ausnehmung eingeführten Dornes weiter zu verbessern.

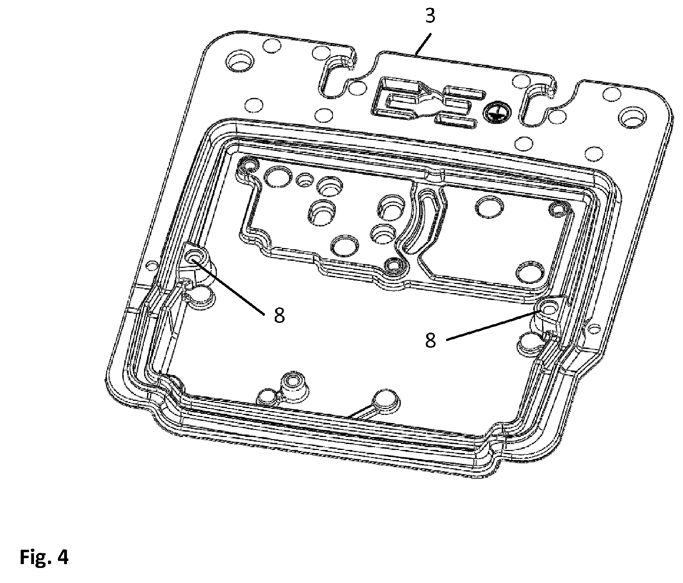

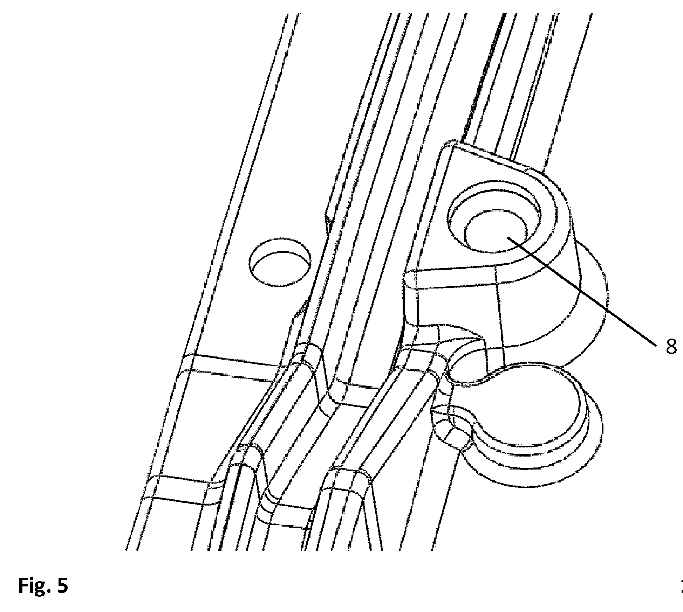

**Fig. 4** zeigt einen Boden 3 des elektronischen Gerätes 1 in perspektivische Darstellung. Korrespondierend zu den zwei Dornen 7 aus **Fig. 2** weist der Boden 2 Ausnehmungen 8 auf, die so angeordnet sind, dass bei der Montage des Deckels 2 auf den Boden 3 die Dorne 7 in die Ausnehmungen 8 eingeführt werden. Die Ausnehmungen 8 sind in der Ausschnittszeichnung der **Fig. 5** im Detail dargestellt. Der Durchmesser der Ausnehmungen 8 ist so gewählt, dass beim Einführen der Dorne 7 in die Ausnehmungen 8 während der Montage eine Druckkraft zwischen den Druckkanten 9 des Dornes 7 und den Innenwänden der zugeordneten Ausnehmungen 8 erzeugt wird. Die Druckkraft reicht aus, um eine Deformation des Dornes 7 bzw. der Ausnehmung 8 und eine kalte Verschweißung der Druckkanten 9 und der Innenwände der Ausnehmung 8 zu erreichen. Auf diese Weise wird neben der elektrischen Verbindung zwischen den Gehäuseteilen eine Haltekraft zwischen Deckel und Boden erreicht, die ausreicht, die beiden Gehäuseteile zusammen zu halten. Bei der Verwendung einer klebenden Dichtung 6 wird die Haltekraft zwischen Boden 3 und Deckel 2 zumindest so lange aufrechterhalten, bis die Klebewirkung der Dichtung ausreicht, um die beiden Gehäuseteile zusammen zu halten. Auf diese Weise ist es möglich, nach dem Zusammenfügen der Gehäuseteile weitere Montage- oder Transportschritte durchzuführen, ohne ein Aushärten der Dichtung abwarten zu müssen, und ohne eine Anpresskraft durch zusätzlich angebrachte Klemmelemente aufbringen zu müssen. Der Montageprozess wird so erheblich vereinfacht und beschleunigt.

Alternativ zu der beschriebenen Herstellung von Deckel und Boden mittels eines Druckgussverfahrens, insbesondere eines Aluminium-Druckgussverfahrens, kann auch ein Kunststoff-Spritzgussverfahren zum Einsatz kommen. Die Kunststoffteile werden nach ihrer Herstellung teilweise - z.B. auf ihren der Geräteinnenseite zugewandten Flächen - oder vollständig elektrisch leitend beschichtet, z.B. lackiert oder bedampft. Sie sind damit im Sinne der vorliegenden Erfindung als aus leitfähigem Material hergestellt anzusehen. Die elektrisch leitende Verbindung zwischen den Teilen erfolgt in gleicher Weise wie weiter oben beschrieben.

### BEZUGSZEICHENLISTE

- 1: Elektronisches Gerät
- 2: Deckel
- 3: Boden
- 4: Anschlussplatte
- 5: Steckverbindung
- 6: Dichtung
- 7: Dorn
- 8: Ausnehmung
- 9: Druckkante

## Patentansprüche

1. Elektronisches Gerät (1) mit einem Boden (3) als erstem Gehäuseteil und einem Deckel (2) als zweitem Gehäuseteil,
**dadurch gekennzeichnet, dass**
das erste und das zweite Gehäuseteil zumindest teilweise aus leitfähigem Material ausgebildet ist und in einem Montagezustand des elektronischen Gerätes (1) durch ein jeweils einem der beiden Gehäuseteile zugehöriges Befestigungspaar, umfassend einen Dorn (7) mit mindestens drei Druckkanten (9) und einer Ausnehmung (8) mit einem dem Dorn angepassten Öffnungsquerschnitt, elektrisch verbunden ist,
wobei der Dorn (7) im Montagezustand derart in die Ausnehmung (8) hineinragt, dass zwischen den Druckkanten (9) und Wänden der Ausnehmung eine Haltekraft zwischen den beiden Gehäuseteilen ausgeübt wird.

2. Elektronisches Gerät (1) nach Anspruch 1, **dadurch gekennzeichnet, dass** der Dorn (7) und der Deckel (2) als einstückiges Gehäuseteil ausgebildet sind.

3. Elektronisches Gerät (1) nach Anspruch 1, **dadurch gekennzeichnet, dass** der Dorn (7) und der Boden (3) als einstückiges Gehäuseteil ausgebildet sind.

4. Elektronisches Gerät (1) nach einem der vorangehenden Ansprüche, **dadurch gekennzeichnet, dass** eine klebende Dichtung zwischen dem Boden (3) und dem Deckel (2) vorgesehen ist.

5. Elektronisches Gerät (1) nach einem der vorangehenden Ansprüche, **dadurch gekennzeichnet, dass** das elektronische Gerät (1) zusätzlich eine Anschlussplatte (4) aufweist, und dass zwischen Anschlussplatte (4) und Boden (3), beziehungsweise zwischen Anschlussplatte (4) und Deckel (2) eine klebende Dichtung vorgesehen ist.

6. Elektronisches Gerät (1) nach einem der vorangehenden Ansprüche, **dadurch gekennzeichnet, dass** der Dorn (7) genau drei Druckkanten (9) aufweist.

7. Elektronisches Gerät (1) nach einem der vorangehenden Ansprüche, **dadurch gekennzeichnet, dass** der Dorn (7) eine konische Form aufweist.

8. Elektronisches Gerät (1) nach einem der vorangehenden Ansprüche, **dadurch gekennzeichnet, dass** der Dorn (7) im Druckgussverfahren aus Aluminium hergestellt ist.

9. Elektronisches Gerät (1) nach einem der vorangehenden Ansprüche, **dadurch gekennzeichnet, dass** die Gehäuseteile (2, 3) im Montagezustand eine schraubenfreie Verbindung aufweisen.

10. Elektronisches Gerät (1) nach einem der vorangehenden Ansprüche, **dadurch gekennzeichnet, dass** das elektronische Gerät (1) ein Wechselrichter ist.
